# EUROPEAN PATENT APPLICATION

(11) **EP 4 718 500 A1**
(43) Date of publication of application: **01.04.2026**
(21) Application number: 24202626.8
(22) Date of filing: 25.09.2024
(51) Int. Cl.: H01L 21/67

(54) **A METHOD AND SYSTEM FOR MANIPULATING MATERIALS AND/OR COMPONENTS USING A TARGETED LIGHT SYSTEM**

(71) Applicant: Nederlandse Organisatie voor toegepast- natuurwetenschappelijk onderzoek TNO, 2595 DA 's-Gravenhage (NL)
(72) Inventor: GIESBERS, Merijn Peter, 2595 DA 's-Gravenhage (NL); ROSO CASARES, Sergio, 2595 DA 's-Gravenhage (NL)
(74) Representative: V.O.

(57) **Abstract**

The invention provides a method and system for manipulating materials and/or components using a targeted light system. The configuration and interaction of multiple light beams on a target surface is controlled. The method involves the generation and direction of several light beams that converge on the target surface to create overlapping areas where the light beams intersect. These overlapping regions are configured so that their combined energy density surpasses a specific threshold level. This threshold triggers a desired manipulation process of the materials or components located at the target surface. The controlled manipulation is driven by the precise application of high-intensity light in the designated areas.

## Description

### FIELD OF THE INVENTION

The invention relates to a method for manipulating materials and/or components using a targeted light system. The invention also relates to a system for manipulating materials and/or components using targeted light illumination. Furthermore, the invention relates to a device including the system. Further, the invention also relates to microelectronics manufacturing involving transferring electronic components. Additionally, the invention also relates to a laser die transfer method and system.

### BACKGROUND TO THE INVENTION

The field of microfabrication and component assembly has increasingly demanded the precise placement and transfer of microscale materials or components, such as micro-LEDs, onto various substrates. These components are typically used in advanced electronics, including wearables, medical devices, and high-resolution displays. Current methodologies for handling and transferring these diminutive components present several challenges, particularly when working with highly integrated circuits where space and/or precision are stringent requirements.

Traditional methods often employ mechanical pick-and-place techniques, which are not only limited by the physical size of the components they can handle but also by the mechanical stress they impose on delicate parts. As components continue to shrink in size, these mechanical methods become less viable due to their lack of precision and potential for damaging materials.

The traditional mechanical pick-and-place techniques encounter significant limitations concerning the size of components they can effectively handle and also the rate at which these components can be transferred. For instance, components smaller than 100 to 150 micrometers can pose a substantial challenge for these systems; handling such diminutive sizes becomes either impractical or exceedingly slow. Furthermore, the throughput of traditional systems may be limited to a maximum of about 10 components per second. This rate is notably inadequate for applications such as micro-LED displays, where the production process may require the transfer of millions of dies per panel. Consequently, relying on traditional mechanical methods for such tasks proves too slow, rendering it economically unfeasible for mass production of e.g. advanced electronic displays.

Light-based transfer methods (e.g. using lasers or flash lamps) have been developed as an alternative to mechanical techniques, offering non-contact manipulation of components. However, conventional light transfer processes also have significant limitations. For instance, the size of the light beam spot (cf. laser spot), which determines the minimum component size that can be effectively transferred, can be restricted by the optics used in the light system, such as the focal length of the lens. This restriction makes it challenging to achieve the high precision required for transferring increasingly smaller components, which are often less than 70 micrometer, or even less than 50 micrometer in size.

Furthermore, existing light transfer methods struggle with the precise control of energy density at the target surface. To initiate the transfer or manipulation of a component, a specific threshold of energy density must be reached, which is difficult to maintain uniformly across a target area using a single light/laser beam. Inconsistencies in energy distribution can lead to incomplete or faulty transfers, which are unacceptable in high-stakes applications such as semiconductor manufacturing, medical device fabrication, etc.

Another issue with current light transfer techniques is the alignment and calibration of the system. Many setups require complex and time-consuming alignments that involve multiple substrates and focusing elements. This complexity not only slows down the process but also introduces more points of failure, reducing overall system reliability.

Moreover, the interaction of the laser with the target material often leads to unintended side effects, such as diffraction and defocusing, especially when small apertures or detailed mask patterns are used. These effects can degrade the precision of the light transfer process, leading to further inconsistencies and defects in the placement of components on the substrate.

These challenges underscore the need for a more adaptable, precise, and reliable method for the manipulation and transfer of small materials or components in manufacturing and assembly processes, such as for example microscale and nanoscale materials/components. Such a method would ideally overcome the limitations of spot size, energy control, and system complexity inherent in existing technologies while accommodating the ongoing trend toward miniaturization in electronic and optical components.

### SUMMARY OF THE INVENTION

It is an object of the invention to provide for a method and a system that obviates at least one of the above-mentioned drawbacks.

Additionally or alternatively, it is an object of the invention to provide for an enhanced method for manipulating materials and/or components using a targeted light system.

Additionally or alternatively, it is an object of the invention to provide for an improved system for manipulating materials and/or components using targeted light illumination.

Additionally or alternatively, it is an object of the invention to improve the process by which different sizes and aspect ratio materials/components can be transferred without the need for changing and using dedicated masks.

Additionally or alternatively, it is an object of the invention to mitigate the limitations created by diffraction effects and potential defocusing during a mask-assisted die transfer process.

Thereto, the invention provides for a method for manipulating materials and/or components using a targeted light system, comprising: providing a plurality of light beams; directing said plurality of light beams towards a target surface such that said light beams at least partially overlap, forming one or more light overlap regions on said target surface; and configuring the overlap of said light beams such that an energy density within said one or more overlap regions exceeds a predetermined threshold value, the threshold value being necessary to initiate a material or component manipulation process.

Components or materials can be manipulated using an array of partially overlapping laser beams. This approach can provide significant advantages when dealing with smaller, densely packed components.

The method enables enhanced precision in material manipulation. By configuring the overlap of light beams such that an energy density within the overlap regions exceeds a predetermined threshold value, it is possible to accurately manipulate specific areas of the material, without affecting neighboring regions.

Another advantage is the elimination of the need for complex alignment of multiple substrates, which is typically required with conventional methods utilizing masks. This not only simplifies the process, but also minimizes the likelihood of errors or damage to components, facilitating a smoother and more efficient operation.

The method further offers the flexibility to alter the effective area of transfer by adjusting the overlap of beams. This makes it possible to handle different material (e.g. die) sizes and aspect ratios without changing or using a dedicated mask.

Moreover, the method does not suffer from diffraction effects that often occur due to the physical distance between the mask layer and the layer holding the dies when using traditional methods.

The technique can also be employed for the transfer of dies and various interconnect materials such as solder paste or conductive adhesive. The light beams can be shaped to correspond to the specific patterns of dies or interconnects needed for certain electronic assemblies.

The method may only require the effective area to be smaller than the light spot (e.g. laser spot), unlike many other conventional laser processes, which makes this technique optimally suited for manipulating small, dense components or materials.

In summary, the invention offers an advantageous technique to manipulate materials with precision, efficiency, and flexibility. Its advantages include accuracy, adaptability, and simplicity compared to traditional methods, making it for example an advantageous approach for dealing with smaller, more densely packed components or materials.

Optionally, the method is employed for transferring materials or components, wherein the energy density in at least non-overlap regions is insufficient to initiate material or component transfer, and wherein a combined light spot in the one or more overlap regions have an energy density sufficient to exceed a threshold energy level required for material or component transfer, and wherein the light spot size and/or shape is adjusted to cover the size and/or shape of at least one part of material or component to be transferred.

The method provides the ability to accurately, efficiently, and selectively manipulate or transfer miniature materials or components (e.g. die). This is particularly beneficial for industries dealing with minute components such as micro-LEDs or small integrated circuits.

The light (e.g. laser) beam is split into multiple beams, and these multiple light beams are directed to adequately overlap on the target surface. The cumulative energy created by the overlapping beams surpasses a set threshold necessary to initiate the transfer process. This ensures that only the area intended for transfer is affected, effectively reducing the risk of unintentional transfers and the associated material waste.

A higher level of flexibility is effectively obtained by actively controlling the size and shape of the overlap region, adjusting it to the precise dimensions of each component. This can be achieved by simply varying the angular orientation and hence the overlap of the beams, thus maintaining high flexibility for different component sizes and shapes without added complexity of utilizing different lenses or masks.

Reliability can also be improved as diffraction effects and defocusing issues, common issues associated with mask-based methods, can be effectively avoided. This makes the invention especially beneficial for applications where precision and reliability are important.

The technique proposed is efficient and practical. Various mechanisms may be used to split the beam and direct the beams onto the target surface. The method provides for a cost-effective solution for manufacturing high-quality products.

Optionally, the plurality of light beams is obtained by splitting one light beam into at least two sub-beams, wherein each sub-beam carries a fraction of the original pulse energy, such that at least some of the overlap regions where split beams coincide reach the predetermined threshold energy density.

Each beam may carry a proportion of the total pulse energy. The controllability of the energy distribution to the targeted areas can be improved. By selectively controlling the overlap of the split beams, the energy density within the overlap regions can be precisely controlled to exceed the predetermined threshold value necessary to initiate the required material or component manipulation process. This control allows the operator to configure the system to suit different applications and achieve the desired effects on different materials and components.

In addition, the method allows for a more efficient use of the light energy by ensuring that the energy supplied to the overlapping regions is used efficiently for the intended process. This eliminates wastage of energy and ensures that only the desired areas of the material or component are processed, preventing unnecessary or undesirable effects on non-target regions.

A greater freedom and flexibility is obtained. The system can vary the size and/or shape of the resulting overlap regions according to the applications, materials and components to be processed. This adaptability can be used to process materials and components of different sizes, shapes or aspect ratios without the need for replacement or adjustment of the physical components or structures of the system, such as a mask. The system also offers the flexibility to adjust the focal plane of the laser, avoiding any undesirable distortion effects that can affect the quality of the process and the resultant products.

Optionally, the plurality of light beams is provided using an optical unit selected from a group consisting of an acousto-optic deflector, a diffractive optical element, and a beam splitter.

The overlap of the light beams can create distinct regions on the surface that receive concentrated energy from more than one light beam. By controlling the degree of overlap between beams, it is possible to adjust the energy density in these overlap regions to exceed a predetermined threshold value needed to initiate a specific process, whether that be manipulation or transfer of the target material or component.

By altering the properties of the individual light beams (such as their position, direction or intensity) the optical unit can make it possible to initiate and control the overlap regions in a highly precise manner.

Manufacturing processes often require a certain energy threshold for an operation to take place, and this threshold typically varies depending on the specific attributes of the components or materials involved. The method of the disclosure may rely on this property to conduct manipulation or transfer operations, ensuring that the overlap regions receive an energy density that is higher than the required threshold.

It may be ensured that other parts of the target surface, where the energy density in the non-overlap regions is insufficient, are left undisturbed. The light beam overlap is only adjusted to cover the size and shape of the specific part of the component or material that needs to be transferred.

The employment of the exemplary optical units facilitates the division of a single light beam into multiple sub-beams, each maintaining a portion of the original beam's energy, thus enabling precise control over the overlap and intensity distribution. For instance, employing an acousto-optic deflector includes its ability to dynamically adjust the angle of the light beams, which allows for rapid and precise alterations in the overlap regions without physical movement of the components. This results in a highly adaptable system suitable for varying operational requirements. The diffractive optical element (DOE) can provide the benefit of creating complex light patterns which may be required for targeting specific shapes and sizes of materials, thus expanding the applicability of the system across different types of material manipulation tasks. Meanwhile, a beam splitter may enable consistent and reliable distribution of light energy across multiple beams.

It will be appreciated that a variety of beam splitting technologies can be employed to facilitate the precise control and manipulation of light beams as described. The selection of a particular beam splitting device is contingent on the specific requirements of the task at hand, including the desired precision, the complexity of the light patterns required, and the dynamic adaptability of the system.

Optionally, the overlap regions are dynamically adjustable using at least one acoustic-optic modulator.

The dynamic adjustment of the overlap regions of light beams, which can be achieved through the use of an acoustic-optic modulator, enables real-time alterations of the energy density within the overlap regions.

The acousto-optic modulator or diffractive optical element may modulate the light beams to ensure that the energy density within the overlap areas exceeds a defined threshold value.

Optionally, a carrier with a release stack is positioned on the target surface, the release stack comprising at least two layers, wherein a first layer has material with a higher melting point configured to absorb a light wavelength of the plurality of light beams to heat up without melting, and wherein a second layer positioned adjacent to the first layer has a lower melting point and is configured to melt due to heat transfer from the first layer to the second layer, and wherein the second layer selectively melts in the one or more overlap regions during light illumination and interacts with an adhesive layer to facilitate transfer of a material or component from the carrier to a receiving surface.

Using the targeted light system in conjunction with a carrier layered with a specific release stack proves advantageous for the efficient manipulation and transfer of materials and/or components. The layered release stack is configured so that one layer with a high melting point absorbs the light wavelength of the plurality of beams to heat up without melting. This heat is subsequently transferred to an adjacent layer with a lower melting point, causing it to melt selectively during light illumination. This facilitates the interaction with an adhesive layer, allowing effective transfer of the material or component from the carrier to a receiving surface.

Thermally controlled release stack is utilized for providing a very precise and effective tool to ensure that only the desired materials or components are manipulated and transferred. The use of overlapping light beams set up to meet or exceed a predetermined threshold value ensures the specified region is subjected to the adequate energy density to initiate the manipulation process. This setup eliminates unwanted transfer and interference with adjacent components, attributing to its overall efficiency.

Optionally, the target surface comprises a donor substrate with dies, and the overlapping regions are configured to selectively transfer dies.

The use of overlapping regions makes it possible to dynamically adjust the effective transfer area. This is particularly beneficial when different component sizes and/or aspect ratios are being processed, as the shape of the effective transfer area can be tailored to fit the specific die components.

The selective overlapping of light beams ensures that the energy density in the overlap regions is sufficient to exceed the threshold necessary for die transfer. By ensuring that the energy density in non-overlap regions remains below the threshold required for initiating die transfer, the method minimizes the risk of accidental activation or damage to adjacent dies or other components. This can be achieved through the strategic configuration of the overlap of the light beams, which isolates the transfer process to designated areas.

The capability to adjust the size and shape of the overlap regions allows it to accommodate a range of die dimensions and configurations of dies.

For dies smaller than 100 microns, including those as diminutive as 50 microns or even less than 30 microns, the precise tailoring of the effective transfer area ensures that the energy density is appropriately concentrated. This capability is crucial for achieving effective die transfer without compromising the integrity of adjacent micro-components/materials. By selectively isolating the transfer energy to match the exact dimensions of these minute dies, the system not only enhances the accuracy of component placement but also significantly reduces the risk of unintentional activations or damage, thereby increasing the yield and reliability of the microfabrication process.

Experiments have shown that the method of the disclosure can be used for transfer of dies as small as for example 5 × 5 µm². Many traditional methods are not capable of achieving this.

The application of this method extends beyond the manipulation of dies smaller than 100 micrometers and proves equally effective for handling large aspect ratio dies, which can exceed 100 micrometers in size. This adaptability can be important for accommodating a diverse range of die dimensions and shapes encountered in advanced microfabrication. By adjusting the overlapping regions of the light beams, the system can be tailored to efficiently handle larger dies without sacrificing precision or risking damage to the dies or adjacent components.

Optionally, materials or components are transferred only when the overlapping light spots substantially cover said materials or components.

This configuration can reduce the risk of unintentionally manipulating or damaging adjacent components. Often, in closely packed materials or components, there is a risk that a manipulation technique may affect non-targeted neighboring components. However, with the overlapping light spots technique, the risk of this unintentional manipulation is greatly reduced. This is accomplished by carefully tailoring the geometrical extent of overlapping light spots. This simply means that the overlap regions are adjusted such that they only extend to substantially cover the targeted material or component area, sparing the neighboring components. This makes the technique particularly useful when dealing with intricate and minute components where precision is of utmost importance.

This technical measure can lead to cost savings, because it minimizes the risk of damage to non-targeted components. Furthermore, its higher precision can also result in improvements in the overall quality and reliability of the assembled product.

Optionally, a focus lens is employed to focus the split beams onto the target surface, wherein an angular difference caused by the acousto-optic deflector and/or the beam splitter of the optical unit positions the beams in a focal plane.

The angular difference between the beams can cause a location difference between the positions of the resulting spots in the focal plane.

Adequate alignment of the diffracted beams on the focal plane of the target surface can be achieved. This precision is facilitated by the angular difference made possible through the use of the acousto-optic deflector. Following the deflection, the beams are processed through a focus lens, which then directs them onto specific positions on the target surface.

Optionally, the overlap of light beams is manipulated to obtain the one or more overlap regions that define an effective transfer area, wherein the effective transfer area is altered in shape to accommodate different component sizes and/or aspect ratios, and wherein the shape of the effective transfer area is controlled by adjusting the degree of overlap among multiple light beams.

The degree of overlap of these beams can be regulated, hence dynamically changing the effective transfer area. By adjusting this overlap, it is possible to cover the entire surface of the component that needs to be transferred, matching the shape of the light spot with that of the component.

This approach is particularly beneficial when handling components of different sizes and aspect ratios, as the overlap can be easily manipulated to achieve the desired shape in real time. This dynamic adjustability eliminates the need for physical masks of specific shapes and dimensions and overcomes the complexities and inaccuracies tied to their usage.

The capacity to adjust the effective transfer area in response to the varying component sizes and aspect ratios offers improved agility and accuracy, delivering a highly effective solution for the precise and efficient transfer of (small) components and/or materials.

Optionally, the target surface is configured such that only regions where the number of overlapping sub-beams exceeds a specified minimum number reach the predetermined threshold energy density necessary for initiating the material or component manipulation process.

By requiring a certain minimum threshold of energy achieved only through the overlap of a specified number of sub-beams, manipulation or transfer processes are initiated only in intended regions. Moreover, this control over the minimum overlap necessary for reaching the energy threshold allows flexibility in the setting. This makes the process highly adaptable for different applications. In the context of transferring dies or other small components, this advantage is particularly significant. The precise transfer or manipulation of such tiny components requires a high degree of accuracy to prevent unintentional impact on adjacent materials or components.

Optionally, the light beams are configured such that the overlap regions formed on the target surface extend into no more than a predetermined fraction of the surface area of adjacent components, and wherein overlap covering less than said predetermined fraction of the surface area of an adjacent component does not result in component transfer.

The overlap regions are restricted to extend into no more than a predetermined fraction of the surface area of adjacent components. By imposing the restriction, the method effectively establishes a "safe zone" for each non-targeted component. Any extension of the overlap cannot exceed this safe zone - therefore, while overlapping may occur, it will be insufficient to reach the necessary energy density to initiate a manipulation process for these non-targeted components. As a result, these components remain unaltered and secure during the manipulation of the targeted components.

This enhanced manipulation of the overlap regions helps to ensure a high degree of precision in the transfer process. The physical area affected by the transfer can be effectively delimited, thereby avoiding any aberrations and ensuring a selective and accurate transfer.

Optionally, the method is applied for transfer of dies and/or interconnect materials such as solder paste or conductive adhesive, wherein the light beams are shaped to form specific patterns that correspond to the shapes of dies and/or interconnects required for one or more electronic assemblies.

By adjusting the overlap of the beams to form specific patterns corresponding to the shapes of the dies and/or interconnects, the method offers a significant amount of customization. This presents a wide range of benefits, allowing electronic assemblies of varied complexities to be assembled effectively and efficiently.

A more efficient solution for the electronic manufacturing industry can be obtained, where precision, speed, and/or adaptability are enhanced. By using multiple overlapping light beams to achieve a higher threshold energy density for manipulation or transfer, this method is equipped to deal with the challenging task of handling exceedingly small components, such as dies that are for example smaller than 50 microns or even smaller than 20 microns.

Optionally, including using a spatial light modulator for dynamic shaping and/or resizing of light spots.

A spatial light modulator (SLM) is a device that imposes some form of spatially varying modulation on a beam of light. It allows the control over the light's intensity, phase, or the state of polarization with a specific spatial pattern. The SLM can enable light spot reshaping/reconfiguration on-the-go, to meet the specific requirements of every different manipulation process. SLM can facilitate an enhanced level of control over the manipulation process. The energy density within the overlap regions can be adjusted accurately to exceed a predetermined threshold value, necessary for the initiation of a material or component manipulation process, improving versatility and providing a high degree of control in beam manipulation, which can lead to an improved effectiveness and wider applicability of the described method.

According to an aspect, the invention provides for a system for manipulating materials and/or components using targeted light illumination, comprising: a light source unit configured to provide a plurality of light beams; a directing unit configured to direct said plurality of light beams towards a target surface such that said light beams at least partially overlap, thereby forming one or more light overlap regions on said target surface; a control unit configured to adjust the overlap of said light beams such that an energy density within said one or more overlap regions exceeds a predetermined threshold value, the threshold value being necessary to initiate a material or component manipulation process.

An improved way of manipulating materials and components is obtained using a system of multiple partially overlapping laser beams, significantly reducing the diameter of the laser spot. This refined laser spot is important for the precision transfer of materials or components, particularly suitable for applications requiring high-energy density at a localized point.

The system facilitates precise micro and nano-scale material/component manipulation using targeted light beams. A light source generates beams directed by a unit to overlap on a target surface, creating high-energy density regions when exceeding a set threshold, for initiating manipulation processes. This adjustable system efficiently manages energy density and beam size, addressing challenges in micro-component manipulation such as control and adaptability to varying component sizes.

A beam-splitting technique may be used to divide a single beam into multiple beams. These beams are then strategically overlapped to amplify the energy density at their intersection.

According to an aspect, the invention provides for a method and system for manipulating materials or components using a targeted light system, wherein multiple light beams are provided, wherein these beams are directed to at least partially overlap on a target surface, and wherein one or more overlap regions are formed, and wherein the overlap is adjusted to achieve an energy density in these regions that exceeds a threshold necessary to initiate manipulation.

The system uses targeted light beams, directed to overlap on a surface and controlled to exceed a specific energy threshold, enabling precise material manipulation.

According to an aspect, the invention provides for a method and system for manipulating materials or components with a targeted light system, wherein multiple light beams are provided and directed to overlap on a target surface, wherein the beam overlap is adjusted to exceed a threshold energy density necessary for manipulation.

According to an aspect, the invention provides for a method and system using a targeted light arrangement to manipulate materials or components, wherein overlapping light beams are directed onto a target surface, and wherein the overlaps are configured to exceed a specified energy density threshold for manipulation.

According to an aspect, the invention provides for a system and method for manipulating materials and/or components using targeted overlapping light beams.

It will be appreciated that while the described invention may refer to the transfer of materials or components, the scope of manipulation is not limited to mere transfer but can encompass various other types of transformations. The targeted light system's ability to manipulate materials does not solely extend to physical relocation from one surface/location to another; it can also involve alteration of material properties, precise activation of chemical processes, or modification of structural attributes at the micro or nano scale. In several examples, the emphasis is placed on transfer, but alternatively, any form of transformation or manipulation that requires precise, localized energy application could be covered by this method.

It will be appreciated that any of the aspects, features and options described in view of the method apply equally to the system and the electric vehicle. It will also be clear that any one or more of the above aspects, features and options can be combined.

It will be appreciated that any of the aspects, features and options described in view of the methods apply equally to the systems and the described devices. It will also be clear that any one or more of the above aspects, features and options can be combined.

### BRIEF DESCRIPTION OF THE DRAWING

The invention will further be elucidated on the basis of exemplary embodiments which are represented in a drawing. The exemplary embodiments are given by way of non-limitative illustration. It is noted that the figures are only schematic representations of embodiments of the invention that are given by way of non-limiting example.

In the drawing:
Fig. 1 shows a schematic diagram of an embodiment of a system;
Fig. 2a, 2b show a schematic diagram of an embodiment of light-based transfer;
Fig. 3 shows a schematic diagram of an embodiment of light-based transfer;
Fig. 4 shows a schematic diagram of an embodiment of an acousto-optic deflector;
Fig. 5a, 5b show a schematic diagram of an embodiment of overlapping light beams;
Fig. 6 shows a schematic diagram of an embodiment of overlapping light beams;
Fig. 7a, 7b shows a schematic diagram of an embodiment of overlapping light beams; and
Fig. 8 shows a schematic diagram of a method.

### DETAILED DESCRIPTION

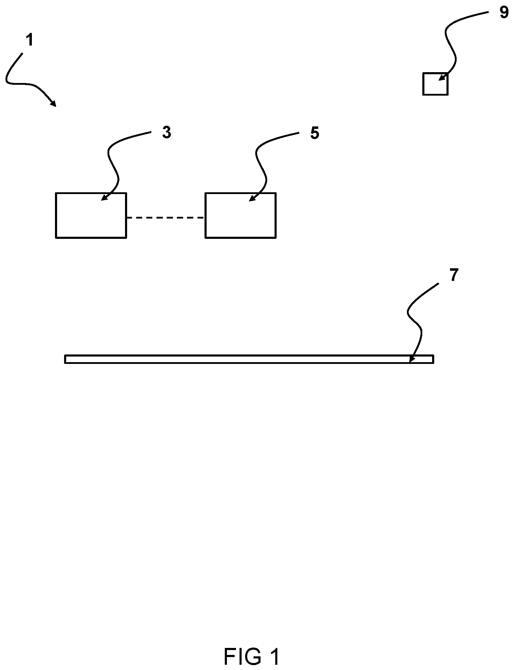

Fig. 1 shows a schematic diagram of an embodiment of a system 1 for manipulating materials and/or components using targeted light illumination. The system comprises a light source unit 3 configured to provide a plurality of light beams, a directing unit 5 configured to direct said plurality of light beams towards a target surface 7 such that said light beams at least partially overlap, thereby forming one or more light overlap regions on said target surface, and a control unit 9 configured to adjust the overlap (not shown in fig. 1) of said light beams such that an energy density within said one or more overlap regions exceeds a predetermined threshold value, the threshold value being necessary to initiate a material or component manipulation process.

The light beams at least partially overlap, creating one or more high-energy overlap regions on the target surface. This overlap can be carefully calibrated such that the energy density within these regions is sufficient to exceed a predetermined threshold value necessary for the manipulation of materials or components. The system allows for a highly controlled manipulation of extremely small components by configuring the overlap of light beams to create a focused area of energy density that can be adjusted according to the component/material size.

This adaptability can be important for future applications where component sizes are expected to decrease significantly. Given the anticipated reduction in component sizes to as small as 10 microns or even 5 microns, the targeted light system is configured to accommodate even smaller spot sizes than currently possible.

Moreover, the system can provide the ability to adjust the overlap regions dynamically such as to enable it to handle different sizes and shapes of materials without the need for changing physical masks or optics, thus reducing complexity and increasing throughput.

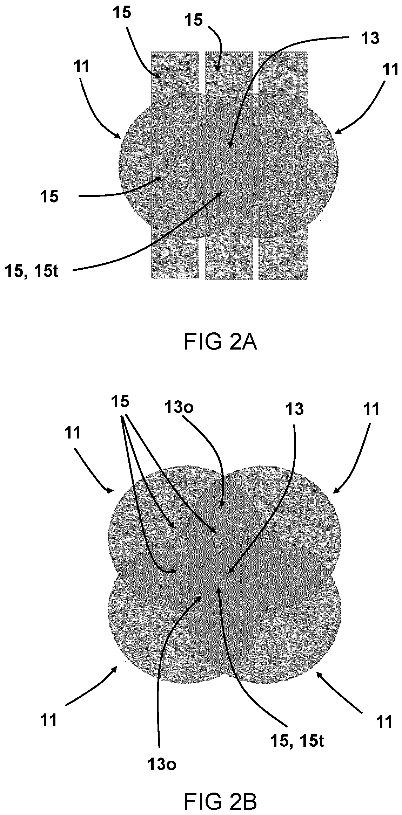

Fig. 2a, 2b show a schematic diagram of an embodiment of light-based transfer for manipulating materials and/or components using a targeted light system. Multiple light beams 11 are directed towards a target surface, wherein the beams 11 are configured to at least partially overlap to form one or more light overlap regions 13 on said target surface.

The light source unit (not shown) is responsible for generating the plurality of light beams 11, while the directing unit (not shown), may include components such as an acousto-optic deflector or a diffractive optical element, such as to position these multiple beams such that they converge on the target surface in order to create the necessary/adequate overlap for achieving the desired light-based transfer. The control unit is configured to adjust the parameters of the light beams such as their configuration, intensity, angle, and focal point to ensure that the energy density within the overlap regions 13 exceeds a predetermined threshold value. This threshold is important to initiate the material or component manipulation process.

In some examples, a carrier with a release stack, which includes layers with differing melting points, is positioned on the target surface. Upon illumination, the targeted areas of the lower melting point layer in the release stack melt due to the heat transfer from the adjacent higher melting point layer, enabling selective transfer of materials or components to a receiving surface.

In some examples, a focus lens may be employed to fine-tune the focus of the split beams onto the target surface, ensuring precise alignment and energy delivery to the intended overlap regions.

In some examples, optional elements such as a spatial light modulator for dynamic reshaping of light spots or additional optical units for further beam manipulation can also be incorporated to enhance the flexibility and precision of the system.

In fig. 2a, multiple transferable components 15 (e.g. dies or electronic components) are shown. Only one transferable component 15t of the exemplary nine transferable components 15 is completely covered by the overlapping of the light beams. As a result, only this component 15t is light-based transferred. The other components may be not sufficiently illuminated for initiating transfer, although the overlapping region 16 partially covers said other transferable components.

Fig. 2b shows four partially overlapping light beams 11, each originating from different angles relative to the target surface. These beams converge to form one or more light overlap regions on the target surface, where the energy density within at least a subset of these regions is configured to exceed a predetermined threshold value necessary for initiating a material or component manipulation process. In this example, only the overlapping region 13 of all four light beams 11 is configured to exceed said threshold value. For example, the partially overlapping region 13o may not result in meeting said threshold value.

The overlapping regions may be configured to precisely align with the desired material or component placement area on the target surface, ensuring accurate and efficient manipulation or transfer without affecting the surrounding areas. The effective transfer area can be dynamically adjusted by varying the angle and intensity of each beam, allowing for manipulation of different sizes and aspect ratios of materials or components.

Also in fig. 2b, multiple transferable components 15 (e.g. dies) are shown. Again, only one transferable component 15t of the exemplary nine transferable components 15 is completely covered by the overlapping of the light beams. As a result, only this component 15t is light-based transferred. The other components may be not sufficiently illuminated for initiating transfer, although the overlapping region 16 partially covers said other transferable components.

When using for example a laser die transfer method, a limiting factor for going towards smaller component (e.g. <50 micrometers) which are densely packed is the laser spot size in combination with a scanner lens, which is needed for a fast process. This limits the progression towards fast laser die transfer of smaller components. Using optics it's possible to obtain for instance two or four partially overlapping laser spots with 50% or 25% of the pulse energy each. Only where all spots overlap, the threshold may be reached for the transfer process to happen. Importantly, regions outside the overlap would be illuminated with too little energy, having no effect on neighboring dies.

In some examples, as confirmed by experiments, overlapping up to around one-third of an adjacent component's surface area with the light spot does not initiate an unintended transfer (this fraction may depend on various parameters and can be different for other scenarios). Even when attempts are made to transfer such a component subsequently, it behaves as expected without any deviation from normal transfer processes. This suggests that the underlying material may melt due to the energy density reaching the threshold, but since the bulk of the component remains solid and anchored, it merely re-solidifies without displacement. Therefore, the integrity of the component is maintained, and it remains suitable for successful transfer thereafter.

Furthermore, it has been shown that the robustness of the targeted light system is further exemplified by its performance irrespective of changes to the material stack composition. The system's effectiveness is not compromised by varying the materials within the stack. The components subjected to the overlapping light beams undergo melting only in the targeted areas, with the remainder of the component staying fixed and unaffected. Thus, the system ensures precise manipulation and transfer of materials or components while maintaining the structural fidelity of the surrounding areas, important for high-precision manufacturing processes.

These above results underscore the adaptability and precision of the targeted light system in handling microscale and nanoscale materials and components.

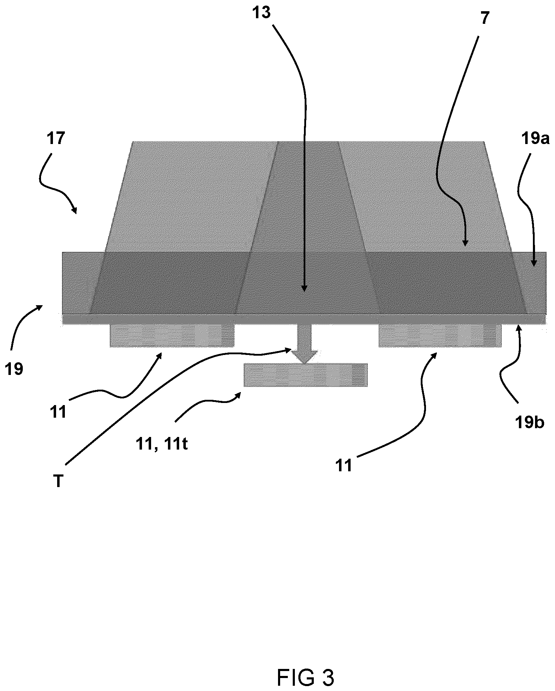

Fig. 3 shows a schematic diagram of an embodiment of light-based transfer. The transfer process utilizes targeted light beams. The figure depicts a cross-sectional view.

A transparent carrier, such as glass, may be employed, coated with a thin release stack. This stack may include for example two layers (e.g. metal): the first is a heat-absorbing metal with a high melting point that absorbs the laser wavelength without melting. The second layer may have a lower melting point and melts during laser illumination due to heat transfer from the first layer. Between the second layer and the component/material (e.g. die or chip), a thin glue/adhesive layer may be applied. This adhesive is chosen to react favorably with the molten metal, facilitating a gentle release from the molten metal layer. This release mechanism is subtle compared to other methods that might use forceful ablation, providing a more controlled and delicate process suitable for transferring delicate components or materials.

In the shown example of fig. 3, the energy density in at least non-overlap regions is insufficient to initiate material or component transfer, and wherein a combined light spot in the one or more overlap regions have an energy density sufficient to exceed a threshold energy level required for material or component transfer, and wherein the light spot size and/or shape is adjusted to cover the size and/or shape of at least one part of material or component to be transferred. Furthermore, a carrier 17 with a release stack 19 is positioned on the target surface 7. The release stack 19 may comprise at least two layers 19a, 19b, wherein a first layer 19a has material with a higher melting point configured to absorb a light wavelength of the plurality of light beams to heat up without melting, and wherein a second layer 19b positioned adjacent to the first layer 19a has a lower melting point and is configured to melt due to heat transfer from the first layer 19a to the second layer 19b, and wherein the second layer 19b selectively melts in the one or more overlap regions 13 during light illumination and interacts with an adhesive layer to facilitate transfer T of a material or component 11t from the carrier 17 to a receiving surface.

Using a mask is the conventional method for laser transferring smaller dies. This shades part of the laser spot so that only the smaller area of the die is illuminated. This firstly adds substantial complexity, as it requires precise alignment of the mask to the laser and the donor substrate with dies (additional wafer alignment step). Secondly, there is a noticeable distance between the mask and the dies (thickness of a donor glass) which in combination with diffraction through a small hole in the mask makes this solution less reliable and more difficult for industrial implementation. Advantageously, the system and method according to the disclosure can effectively mitigate such detrimental effects.

A light beam can be split using various optical units such as an acousto-optic deflector (AOD) or a diffractive optical element (DOE). Each may have its advantages depending on the specific requirements of the transfer process.

An AOD element allows for dynamic adjustment of the beam's angle, providing flexibility to change the overlap quickly and efficiently. This may be particularly advantageous in production settings where the size or type of chip being transferred varies frequently.

A DOE can be designed to direct all energy to a specifically shaped area, matching the shape of the die. This method may be highly effective but less flexible than the acousto-optic deflector as it is generally limited to predefined patterns.

The system may also incorporate other optical arrangements for obtaining multiple overlapping light beams. For example, a spatial light modulators (SLMs) may be used for dynamic beam shaping. This technology enables the manipulation of light spots in real-time, adjusting their size, shape, and intensity to match the specific requirements of the transfer process. SLMs provide a significant advantage in terms of control, allowing for precise adjustments to the energy distribution within the overlap regions. Multiple light beams may be directed to at least partially overlap on a target surface. By adjusting the overlap, the energy density within these regions exceeds a threshold necessary for initiating material manipulation.

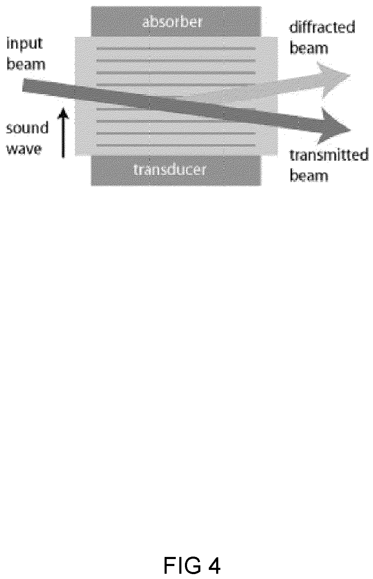

Fig. 4 shows a schematic diagram of an embodiment of an acousto-optic deflector used to split the laser beam. In this example, the laser beam is split into two bundles, each having 50% of the original pulse energy, before entering into a subsequent optical arrangement, such as for instance a laser scanner. The acousto-optic deflector can conventionally be used to continuously change the diffracted beam angle (e.g. up to one degree). Optionally an orthogonally placed secondary acousto-optic modulator can be used to split the beam over the other axis as well.

The beam propagates through the scanner and onto the scanner lens. Due to the small angular difference, the diffracted beam will be imaged at a different position in the focus. Only the area where the two spots overlap will get enough fluence to initiate the laser transfer process for the die under that area. Neighboring dies that are partially exposed under the area where the two spots overlap will not be transferred. In some examples, experiments have shown that if up to a fraction (such as up to around 2/3) of the area of the die is exposed, no transfer happens, and the die is unaffected. This can significantly increases the operational flexibility, allowing for greater freedom in manipulating components without affecting adjacent ones. The experimental results indicate that the material of the component subjected to the overlap may melt due to the heat generated by the overlapping beams. However, the structural integrity of the component remains intact as the melted portion re-solidifies without any movement, maintaining its original position and condition.

In some examples, additionally or alternatively, a diffractive optical element (DOE) can be used.

In some examples, a laser scanning system equipped with dual mirrors and a focus lens may be employed to facilitate the rapid and precise manipulation of materials and components using targeted light beams. The focus lens may be an integral component of the system, consisting of multiple optical elements arranged sequentially to form what is often referred to as an f-theta lens. This arrangement of lens elements may be configured to maintain a consistent focus across the entire scanning field, countering the natural focal length variations that simpler lenses experience over distance.

In operation, the laser beam may first enter the scanner, where it is deflected by two mirrors responsible for adjusting the beam's x and y coordinates, respectively. This two-mirror system may allow for swift and accurate positioning of the laser spot across different target locations on the surface. The exaggerated angles depicted in fig. 4 helps to clarify the path of the beam through the scanner: initially reflecting off the x-axis mirror and subsequently the y-axis mirror, before passing through the focus lens.

The focus lens, which may include an acousto-optic deflector (AOD), may be configured to flatten the focus over the entire scanner field. With a standard lens, the focal distance varies depending on the beam's entry point relative to the center of the field. As the beam moves from the center towards the edges, the distance changes, potentially leading to focal inconsistencies. However, the use of multiple lens elements within the focus lens compensates for these variations, ensuring a uniformly flat focus across the field.

Employing such scanning system, inclusive of the f-theta lens and its multiple optical components, allows to effectively enhance the speed and precision of laser-based material manipulation compared to traditional mechanical methods. This system's ability to quickly direct the laser beam to numerous precise locations makes it highly effective for the rapid and accurate transfer of dyes and other components.

It will be appreciated that while in some examples a scanning system and a focus lens system may be used, simpler lens configurations could also be utilized within the scope of the invention.

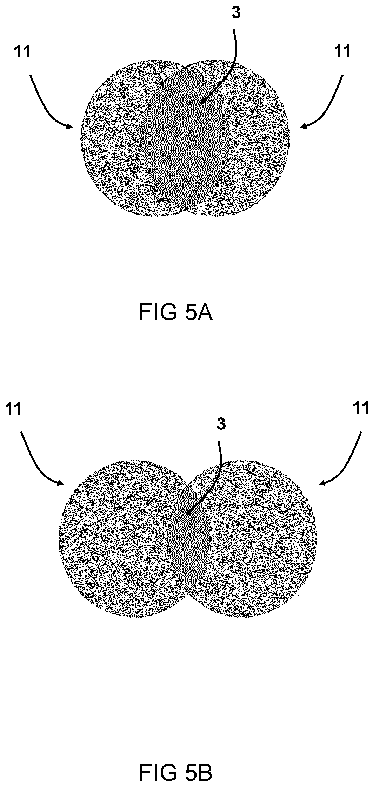

Fig. 5a, 5b show a schematic diagram of an embodiment of overlapping light beams 11. These figures illustrate overlapping beams 11 with more overlap (fig. 5a) and less overlap (fig. 5b) for respectively larger and smaller active laser transfer areas.

As seen on fig. 5b, when reducing the overlap 3 for a smaller effective area, the effective transfer area becomes more elongated. Various overlapping configurations can be obtained. A smaller and/or more symmetrical effective transfer area can be obtained, as illustrated in fig. 2b. In that example, only the central part of the overlapping spots, where all four spots overlap, may get enough fluence to initiate the transfer process. Such configuration of overlapping beams in fig. 2b may for instance be obtained advantageously using two orthogonally placed acousto-optic deflectors. However, it will be appreciated that other arrangements may also be employed for achieving such overlapping beam configuration with four. Other number of overlapping beams may also be used.

The arrangement demonstrates a specific geometrical alignment where the extent of overlap can be optimized, thus enabling precise manipulation of materials or components located within this region. Different degrees of overlap may influence the shape of the overlap region. This variation can represent an operational mode where the energy density and the shape of the overlap region are adjusted to suit different operational requirements or to handle materials or components of varying sizes or properties. The system can effectively adapt the spatial arrangement of light beams to create customizable overlap regions.

The system has an enhanced flexibility in adjusting the overlap, which allows for dynamic control of the energy density imparted to the target surface, thereby accommodating a broader range of material and/or component manipulation scenarios.

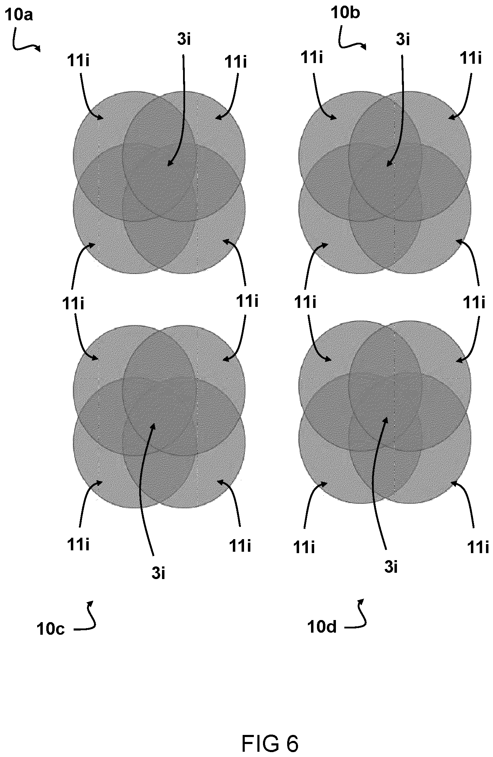

Fig. 6 shows a schematic diagram of an embodiment of overlapping light beams. In this example, an array of overlapping light beams is employed in a targeted light system for the manipulation of materials or components. The figure shows exemplary four instances 10a, 10b, 10c, 10d each showing configurations of multiple light beams arranged to overlap and form concentrated energy regions on a target surface.

In this example, each instance 10a, 10b, 10c, 10d depicts a configuration where four light 11i beams intersect, creating an overlap region 3i at the center where the energy density exceeds a predetermined threshold necessary for initiating material or component manipulation. Hence, all instances show a similar setup with four light beams. However, a different number of overlapping light beams may also be used. Additionally or alternatively, some instances may have slightly altered geometry, resulting in a different shape and size of the central overlap region 3i, demonstrating the flexibility of the system to adjust the effective area of energy concentration.

Alternative to the shown example in fig. 6, in some examples, a configuration may be employed where the arrangement and angular orientation of the beams are modified, altering the shape and distribution of the overlap region to adapt to different material sizes or component shapes.

The system can efficiently manipulate the overlap of light beams in order to create regions with sufficiently high energy density for precise and controlled material or component handling. The system has a high adaptability and efficacy in handling diverse sizes and shapes of materials or components without the need for physical reconfiguration of the system components, such as masks or lenses. This can enhance the system's utility in some applications such as manufacturing processes. For example, in microelectronics fabrication, precise placement and minimal component damage are important.

The shown example in Fig. 6 illustrates simultaneous instances of overlapping light beams, where multiple beams intersect at the same time to create concentrated energy regions on a target surface. However, it is also envisaged that such instances can be obtained sequentially by dynamically redirecting the laser beams to different target areas. In this sequential approach, the system first configures the beams to create an overlap region corresponding to instance 10a. Once the desired material or component manipulation is achieved in this region, the system can then redirect the beams to form the overlap region corresponding to instance 10b, and so on. This sequential manipulation allows for precise control over the order and location of energy concentration on the target surface, enabling the system to handle multiple areas or components one after the other. This method not only increases the flexibility of the system but also reduces the potential for interference between simultaneous overlapping regions, thereby enhancing the precision of the material manipulation process. Additionally, this approach can be particularly advantageous in applications requiring highly localized adjustments or when dealing with complex geometries, as it permits targeted manipulation without the need to physically move or reconfigure the optical components.

In some examples, in addition to sequentially obtaining overlapping light beam instances, the system may be configured to adapt these instances on-the-fly, allowing for configurations with varying beam arrangements in real-time. This adaptability enables the system to modify the overlap regions dynamically as each subsequent instance is generated, tailoring the beam configuration to suit the specific requirements of the material or component being manipulated at that moment. For example, after completing the manipulation in the first instance, the system can immediately adjust the angular orientation, intensity, or positioning of the light beams to create a different overlap region for the second instance. This ability to rapidly reconfigure the beam setup without interrupting the operation enhances the system's efficiency and versatility. It allows for seamless transitions between different manipulation tasks, accommodating variations in material size, shape, or required energy distribution. This real-time configurability is particularly beneficial in applications that demand high precision and adaptability, such as in advanced manufacturing or microelectronics, where the ability to adjust the beam configuration on-the-fly ensures optimal performance and minimizes the risk of damage or errors during the manipulation process.

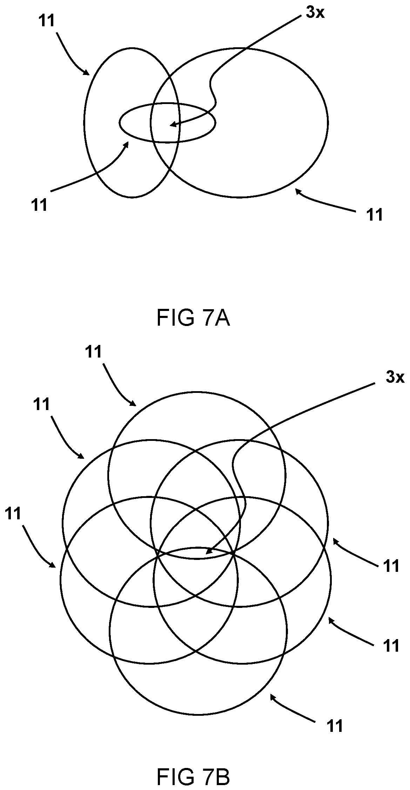

Fig. 7a, 7b shows a schematic diagram of an embodiment of overlapping light beams 11. Two distinct schematic configurations with overlapping light beams used in a targeted light system for manipulating materials or components are given. Each configuration illustrates different exemplary arrangements and interactions of multiple light beams to form specific overlap regions 3x where the energy density is managed to exceed a predetermined threshold for effective material or component manipulation.

In fig. 7a, three distinct light beams 11 are employed having irregular shapes, demonstrating the flexibility of beam shaping within the system. Each beam is individually identifiable and contributes to the overall energy density in the overlap area. The most central area where all three beams intersect is labeled as overlap region 3x. This region is important as it represents the zone of maximum energy concentration, advantageously utilized for manipulating materials for example at a micro or nanoscale level. The shape and extent of this region can be important for effectively ensuring precise application of energy to target materials without impacting surrounding areas.

The exemplary configuration shown in fig. 7b shows six overlapping circular beams. Each beam overlaps with at least one other, creating a complex network of intersecting areas that can be finely controlled for targeted material manipulation. The focus is on the central overlapping region 3x where the interaction of all beams is maximized. This area is designed to function as the primary zone for achieving the necessary threshold energy density, making the size of the area in which manipulation can occur significantly smaller compared to using singular beams for that purpose. This can be of great importance for processes such as the transfer of micro-LEDs, semiconductor dies, or other small-scale components, etc. Moreover, this configuration allows for the manipulation of components with high precision, minimizing the risk of unintentional impacts on adjacent components.

Each configuration within fig. 7a, 7b serves to exemplify the principle of using multiple overlapping light beams to create high energy density regions for precise material or component manipulation. The specific exemplary geometric arrangements of the beams suggest variability in the system's capability to adapt the overlap regions in accordance with the shape and size requirements of different components or materials being manipulated.

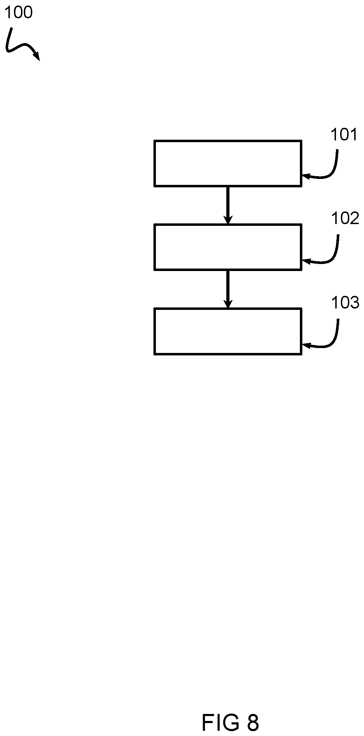

Fig. 8 shows a schematic diagram of a method 100 for manipulating materials and/or components using a targeted light system. In a first step 101, a plurality of light beams is provided. In a second step 102, said plurality of light beams are directed towards a target surface such that said light beams at least partially overlap, forming one or more light overlap regions on said target surface. In a third step 103, the overlap of said light beams is configured such that an energy density within said one or more overlap regions exceeds a predetermined threshold value, the threshold value being necessary to initiate a material or component manipulation process.

In some examples, a targeted light exposure method 101 is employed to manipulate materials or components. In a first step 101, overlapping light beams are directed onto a target surface. In a second step 102, the overlaps are configured to exceed a specified energy density threshold for manipulation.

A method for manipulating materials and/or components is obtained using targeted overlapping light beams. Advantageously, the method effectively enables to reach a smaller effective transfer area and does not use a mask. This can be achieved using optical units for beam manipulation to achieve targeted overlapping.

There is no need to do very accurate complex alignment of multiple substrates with respect to each other.

Using a mask, many dies are shaded while the mask is in place. Shaded dies can only be addressed after the mask is moved to a new position. With the method of the disclosure, more flexibility is obtained, and any exemplary component/material (e.g. die) in the field of view can be addressed at all times.

Different aspect ratio dies and different die sizes may be transferred without changing and using a dedicated mask, by playing with the overlap, for example by using an elongated effective transfer area, as shown in fig. 5b and fig. 7b. When using a mask, diffraction effects and possibly defocusing and diffraction through a small hole can happen due to the physical distance between the mask layer and the layer that holds the dies, as these are separated by a layer of carrier material. This issue is mitigated in the method according to the disclosure.

For making smaller spot sizes usually shorter focal length lenses are used, resulting in a smaller spot, but also in a smaller field of view. However, the spot size is typically inherently limited by the optics governing the laser parameters in combination with the focal length of the optics. Due to the limited availability of shorter focal length optics for scanner lenses, this limits the spot size that can be reached, hampering the selective transfer of densely packed components for instance smaller than 50 micrometers. The method according to the disclosure does not need the whole spot to be smaller, but only the effective area which has a fluence above the threshold.

It will be appreciated that while numerous embodiments herein describe the transfer of materials or components, the scope of manipulation achievable with the disclosed targeted light system extends beyond mere transfer to encompass a variety of transformative processes. This system, through its precise control of light energy, is not constrained to the physical relocation of materials from one substrate to another but is equally adept at facilitating modifications to the material properties themselves, initiating localized chemical reactions, or altering microstructural attributes. Thus, the utility of the described method is not confined to transfer alone but also includes any operation that necessitates exact, localized application of energy, thereby broadening the potential applications of the technology across a spectrum of industrial processes that demand high precision and adaptable manipulation capabilities in materials engineering and processing. This versatility enhances the method's applicability in advanced manufacturing sectors, including but not limited to, semiconductor fabrication, biomaterial processing, and photonic circuit development.

It will be appreciated that laser die transfer may refer to a technology used for example in the microelectronics and semiconductor industries. This process involves transferring very small components, often referred to as dies, from one surface to another using laser energy. It may be a part of the assembly process for various types of electronic devices.

Dies may be understood as compact blocks of semiconducting material that contain integrated circuits and/or other electronic components. These dies may need to be precisely placed and attached to a substrate or package to create functional electronic devices.

In laser die transfer, a laser beam may be used to either detach a die from its initial wafer or to assist in placing and bonding the die onto a new substrate. The laser can be used to heat the adhesive or the substrate to facilitate this transfer without physically touching the die, which reduces the risk of mechanical damage.

The use of lasers allows for very precise control over the amount of energy applied and the location of its application. This precision can be important for handling microscale components without causing damage. It also speeds up the process compared to traditional mechanical methods.

Laser die transfer is used in various applications including the assembly of LEDs, sensors, and other micro-components which require high precision and reliability.

It will be appreciated that while the description may reference the use of laser technology, the principles and methods disclosed herein are equally applicable using alternative light sources such as flash lamps or other similar means. These alternative light sources can also provide the necessary energy density and precise control required for the manipulation of materials and components, offering flexibility in selecting the appropriate technology based on specific application needs or available resources.

The utilization of a flash lamp system in the manipulation of materials and components involves the generation of high-intensity, pulsed light capable of precise spatial control when integrated with appropriate optical elements. A flash lamp can produce a broad spectrum of light, which can be selectively filtered and focused to create specific beam profiles necessary for targeted operations. For instance, by coupling a flash lamp with optical devices such as lenses, mirrors, and beam splitters, the emitted light can be shaped into multiple, distinct beams that overlap on a target surface to achieve the required energy density. These beams can be dynamically adjusted in terms of intensity, focus, and overlap through the use of optical modulators or deflectors, allowing for flexible manipulation of materials without physical contact.

It will be appreciated that an acousto-optic deflector (AOD) may be understood as a device that uses sound waves to control the direction of light beams. It operates on the principle of acousto-optic effect, which involves the interaction between sound waves and light waves within a medium. As the sound waves travel through the medium, they create a periodic variation in the refractive index of the material, forming a moving diffraction grating. When a beam of light (e.g. laser light) passes through the medium, it interacts with the diffraction grating. The light is diffracted at different angles depending on the frequency of the sound waves. By adjusting the frequency of the sound waves, the angle of deflection of the light beam can be precisely controlled. The output is a deflected beam of light whose angle can be rapidly changed by modifying the sound wave frequency. This makes AODs highly useful for dynamically scanning light across a range or rapidly switching it between paths in optical systems.

An AOD can split a laser beam into two or more separate beams. This occurs as a result of the diffraction process when the laser beam interacts with the acoustic wave-generated diffraction grating within the AOD. When a laser beam enters the AOD, it can be diffracted into several orders, with each order corresponding to a specific angle of deflection.

It will be appreciated that any of the aspects, features and options described in view of the method apply equally to the system and the electric vehicle. It will also be clear that any one or more of the above aspects, features and options can be combined.

It will be appreciated that a diffractive optical element (DOE) may be understood as a device designed to manipulate light in specific ways by structuring its surface to produce diffraction patterns. These elements are used to shape and distribute light beams precisely. DOEs can have microstructures, patterns of tiny grooves or optical features, that are etched or molded onto a substrate material like glass or plastic. These patterns are designed to exploit the principles of diffraction. When a coherent light source, like a laser, illuminates the DOE, the light waves interact with the microstructures. This interaction causes the light waves to diffract and interfere, forming new light wavefronts. The specific design of the microstructure controls how these wavefronts interfere, thus shaping the resulting light beam. By designing the surface pattern appropriately, DOEs can split a single light beam into multiple beams in predetermined directions. They can also transform a Gaussian beam into a more complex shape, like a top-hat or a ringshaped profile.

It will be appreciated that beam splitters may be understood as optical devices that split incoming light into two or more beams at a designated ratio (e.g., 50/50) by using a partially reflective coating. Different types of beam splitters exist and can be employed.

Some embodiments may be implemented, for example, using a machine or tangible computer-readable medium or article which may store an instruction or a set of instructions that, if executed by a machine, may cause the machine to perform a method and/or operations in accordance with the embodiments.

Various embodiments may be implemented using hardware elements, software elements, or a combination of both. Examples of hardware elements may include processors, microprocessors, circuits, application specific integrated circuits (ASIC), programmable logic devices (PLD), digital signal processors (DSP), field programmable gate array (FPGA), logic gates, registers, semiconductor device, microchips, chip sets, et cetera. Examples of software may include software components, programs, applications, computer programs, application programs, system programs, machine programs, operating system software, mobile apps, middleware, firmware, software modules, routines, subroutines, functions, computer implemented methods, procedures, software interfaces, application program interfaces (API), methods, instruction sets, computing code, computer code, et cetera.

Herein, the invention is described with reference to specific examples of embodiments of the invention. It will, however, be evident that various modifications, variations, alternatives and changes may be made therein, without departing from the essence of the invention. For the purpose of clarity and a concise description, features are described herein as part of the same or separate embodiments, however, alternative embodiments having combinations of all or some of the features described in these separate embodiments are also envisaged and understood to fall within the framework of the invention as outlined by the claims. The specifications, figures and examples are, accordingly, to be regarded in an illustrative sense rather than in a restrictive sense. The invention is intended to embrace all alternatives, modifications and variations which fall within the scope of the appended claims. Further, many of the elements that are described are functional entities that may be implemented as discrete or distributed components or in conjunction with other components, in any suitable combination and location.

In the claims, any reference signs placed between parentheses shall not be construed as limiting the claim. The word 'comprising' does not exclude the presence of other features or steps than those listed in a claim. Furthermore, the words 'a' and 'an' shall not be construed as limited to `only one', but instead are used to mean `at least one', and do not exclude a plurality. The term "and/or" includes any and all combinations of one or more of the associated listed items. The mere fact that certain measures are recited in mutually different claims does not indicate that a combination of these measures cannot be used to an advantage.

## Claims

1. A method for manipulating materials and/or components using a targeted light system, comprising:
providing a plurality of light beams;
directing said plurality of light beams towards a target surface such that said light beams at least partially overlap, forming one or more light overlap regions on said target surface; and
configuring the overlap of said light beams such that an energy density within said one or more overlap regions exceeds a predetermined threshold value, the threshold value being necessary to initiate a material or component manipulation process.

2. The method of claim 1, wherein the method is employed for transferring materials or components, wherein the energy density in at least non-overlap regions is insufficient to initiate material or component transfer, and wherein a combined light spot in the one or more overlap regions have an energy density sufficient to exceed a threshold energy level required for material or component transfer, and wherein the light spot size and/or shape is adjusted to cover the size and/or shape of at least one part of material or component to be transferred.

3. The method of claim 1 or 2, wherein the plurality of light beams is obtained by splitting one light beam into at least two sub-beams, wherein each sub-beam carries a fraction of the original pulse energy, such that at least some of the overlap regions where split beams coincide reach the predetermined threshold energy density.

4. The method of claim 1, 2 or 3, wherein the plurality of light beams is provided using an optical unit selected from a group consisting of an acousto-optic deflector, a diffractive optical element, and a beam splitter.

5. The method of claim 4, wherein the overlap regions are dynamically adjustable using at least one acoustic-optic modulator.

6. The method of any one of the claims 2-5, wherein a carrier with a release stack is positioned on the target surface, the release stack comprising at least two layers, wherein a first layer has material with a higher melting point configured to absorb a light wavelength of the plurality of light beams to heat up without melting, and wherein a second layer positioned adjacent to the first layer has a lower melting point and is configured to melt due to heat transfer from the first layer to the second layer, and wherein the second layer selectively melts in the one or more overlap regions during light illumination and interacts with an adhesive layer to facilitate transfer of a material or component from the carrier to a receiving surface.

7. The method of any one of the claims 2-6, wherein the target surface comprises a donor substrate with dies, and the overlapping regions are configured to selectively transfer dies.

8. The method of any one of the preceding claims 2-7, wherein materials or components are transferred only when the overlapping light spots substantially cover said materials or components.

9. The method of any one of the preceding claims 4-8, wherein a focus lens is employed to focus the split beams onto the target surface, wherein an angular difference caused by the acousto-optic deflector and/or the beam splitter of the optical unit positions the beams in a focal plane.

10. The method of any one of the preceding claims, wherein the overlap of light beams is manipulated to obtain the one or more overlap regions that define an effective transfer area, wherein the effective transfer area is altered in shape to accommodate different component sizes and/or aspect ratios, and wherein the shape of the effective transfer area is controlled by adjusting the degree of overlap among multiple light beams.

11. The method of any one of the preceding claims 3-10, wherein the target surface is configured such that only regions where the number of overlapping sub-beams exceeds a specified minimum number reach the predetermined threshold energy density necessary for initiating the material or component manipulation process.

12. The method of any one of the preceding claims 2-11, wherein the light beams are configured such that the overlap regions formed on the target surface extend into no more than a predetermined fraction of the surface area of adjacent components, and wherein overlap covering less than said predetermined fraction of the surface area of an adjacent component does not result in component transfer.

13. The method of any one of the preceding claims 2-12, wherein the method is applied for transfer of dies and/or interconnect materials such as solder paste or conductive adhesive, wherein the light beams are shaped to form specific patterns that correspond to the shapes of dies and/or interconnects required for one or more electronic assemblies.

14. The method of any one of the preceding claims, further including using a spatial light modulator for dynamic shaping and/or resizing of light spots.

15. A system for manipulating materials and/or components using targeted light illumination, comprising:
a light source unit configured to provide a plurality of light beams;
a directing unit configured to direct said plurality of light beams towards a target surface such that said light beams at least partially overlap, thereby forming one or more light overlap regions on said target surface;
a control unit configured to adjust the overlap of said light beams such that an energy density within said one or more overlap regions exceeds a predetermined threshold value, the threshold value being necessary to initiate a material or component manipulation process.
